# EUROPEAN PATENT APPLICATION

(11) **EP 2 320 473 A1**
(43) Date of publication of application: **11.05.2011**
(21) Application number: 09806760.6
(22) Date of filing: 14.08.2009
(51) Int. Cl.: H01L 31/04

(54) **SOLAR CELL MANUFACTURING METHOD AND MANUFACTURING DEVICE**

(30) Priority: 15.08.2008 JP 2008209209
(71) Applicant: Ulvac, Inc., Chigasaki-shi Kanagawa 253-8543 (JP)
(72) Inventor: YAMAMURO Kazuhiro, Chigasaki-shi Kanagawa 253-8543 (JP); YUYAMA Junpei, Chigasaki-shi Kanagawa 253-8543 (JP); YAMANE Katsumi, Chigasaki-shi Kanagawa 253-8543 (JP)
(74) Representative: Eisenführ, Speiser & Partner
(86) International application number: PCT/JP2009/064361
(87) International publication number: WO 2010/018869

(57) **Abstract**

A photovoltaic cell manufacturing method includes: detecting a structural defect (A1, A2) existing in compartment elements (21); obtaining an image (M) by capturing a region including the structural defect (A1, A2) and the scribe line (19) with a predetermined definition; specifying first number of pixels on the image, the first number of pixels corresponding to a distance between the scribe lines (19) adjacent to each other or corresponding to a width of the scribe line (19); referring to an actual value indicating the distance between the scribe lines (19) adjacent to each other or indicating the width of the scribe line (19), the distance being preliminarily stored, and the width of the scribe line (19) being preliminarily stored; calculating an actual size of one pixel on the image (M) by comparing the first number of pixels with the actual value; specifying second number of pixels on the image, the second number of pixels corresponding to the distance between the structural defect (A1, A2) and the scribe line (19); comparing the second number of pixels with the actual size of one pixel, thereby calculating defect position information; and electrically separating the structural defect (A1, A2) by irradiation with the laser light based on the defect position information.

## Description

### BACKGROUND OF THE INVENTION

### Field of the Invention

The present invention relates to a photovoltaic cell manufacturing method and a photovoltaic cell manufacturing apparatus, and specifically relates to a photovoltaic cell manufacturing method and a photovoltaic cell manufacturing apparatus that are capable of quickly detecting and repairing a structural defect at a low cost.

This application claims priority from Japanese Patent Application No. 2008-209209 filed on August 15, 2008, the contents of which are incorporated herein by reference in their entirety.

### Background Art

In recent years, in view of efficient use of energy, photovoltaic cells have been more widely used than ever before.

Specifically, a photovoltaic cell in which a silicon single crystal is utilized has a high level of energy conversion efficiency per unit area.

However, in contrast, in the photovoltaic cell in which the silicon single crystal is utilized, a silicon single crystal ingot is sliced, and a sliced silicon wafer is used in the photovoltaic cell; therefore, a large amount of energy is spent for manufacturing the ingot, and the manufacturing cost is high.

Specifically, at the moment, in a case of realizing a photovoltaic cell having a large area which is placed out of doors or the like, when the photovoltaic cell is manufactured by use of a silicon single crystal, the cost considerably increases.

Consequently, as a low-cost photovoltaic cell, a photovoltaic cell that can be further inexpensively manufactured and that employs a thin film made of amorphous silicon is in widespread use.

An amorphous silicon photovoltaic cell uses semiconductor films of a layered structure that is referred to as a pin-junction in which an amorphous silicon film (i-type) is sandwiched between p-type and n-type silicon films, the amorphous silicon film (i-type) generating electrons and holes when receiving light.

An electrode is formed on both faces of the semiconductor films.

The electrons and holes generated by sunlight actively transfer due to a difference in the electrical potentials between p-type and n-type semiconductors, and a difference in the electrical potentials between both faces of the electrodes is generated when the transfer thereof is continuously repeated.

As a specific structure of the amorphous silicon photovoltaic cell as described above, for example, a structure is employed in which a transparent electrode is formed as a lower electrode by forming TCO (Transparent Conductive Oxide) or the like on a glass substrate, and a semiconductor film composed of an amorphous silicon and an upper electrode that becomes an Ag thin film or the like are formed thereon.

In the amorphous silicon photovoltaic cell that is provided with a photoelectric converter constituted of the foregoing upper and lower electrodes and the semiconductor film, the difference in the electrical potentials is small if each of the layers having a large area is only uniformly formed on the substrate, and there is a problem in that the resistance increases.

Consequently, the amorphous silicon photovoltaic cell is formed by, for example, forming compartment elements so as to electrically separate the photoelectric converter thereinto by a predetermined size, and by electrically connecting adjacent compartment elements with each other.

Specifically, a structure is adopted in which a groove that is referred to as a scribing line is formed on the photoelectric converter having a large area uniformly formed on the substrate by use of laser light or the like, a plurality of compartment elements formed in a longitudinal rectangular shape is obtained, and the compartment elements are electrically connected in series.

However, in the amorphous silicon photovoltaic cell having the foregoing structure, it is known that several structural defects occur during a manufacturing step therefor.

For example, in forming the amorphous silicon film, the upper electrode and the lower electrode may be locally short-circuited because particles mix thereto or pin holes occur therein.

In the photoelectric converter as mentioned above, when structural defects occur such that the upper electrode and the lower electrode are locally short-circuited with the semiconductor film interposed therebetween, the defects cause malfunction such that power generation voltage or photoelectric conversion efficiency are degraded.

Consequently, in the process for manufacturing a conventional amorphous silicon photovoltaic cell, by detecting the structural defects such as the foregoing short-circuiting or the like and by removing (electrically separating) the portions (regions) at which the structural defects exist, malfunction is improved.

Conventionally, in a case of removing portions on a compartment element at which a structural defect occurs, a method is commonly known which forms a groove (repair line) so as to surround the structural defect with laser light, electrically separates the region at which the structural defect exists from the portions at which the structural defect does not exist, and thereby prevents drawbacks such as short-circuiting (for example, Japanese Unexamined Patent Application, First Publication No. S61-96774).

When positioning of the position that is irradiated with the laser light, for example, an irradiation vestige is formed by irradiating an optional point on the compartment element with laser light, thereafter, a stage on which a photovoltaic cell is mounted is moved by a predetermined distance, and an irradiation vestige is formed by re-irradiating with the laser light.

Next, the region including the foregoing two irradiation vestiges is captured by use of a capturing device or the like, and the number of pixels between two irradiation vestiges is measured on the obtained image.

Consequently, the movement distance (real scale) of the stage per one pixel is specified based on the number of pixels between two irradiation vestiges and based on the movement distance of the stage.

Movement of the stage is controlled so that a structural defect image of the image coincides with the position which is irradiated with a laser, based on a conversion value between one pixel of the image obtained in the above-described manner and the actual size on the stage.

However, in the above-described conventional method for controlling the position which is irradiated with laser light, the distance between the capturing device and the photovoltaic cell fluctuates, or the actual size per one pixel in the captured image is changed every change of a capturing magnification ratio.

Because of this, a defect-repair repairing step is necessary, in which time and effort are required such that the actual size per one pixel is freshly calculated for each individual photovoltaic cell, the stage is thereafter transferred, and the position which is irradiated with the laser light is adjusted.

In addition, since it is necessary to form a laser vestige that becomes a marking on a compartment element of the photovoltaic cell every calculating of the actual size per one pixel, there is a problem in that unnecessary damage is imparted to the compartment element.

The invention was conceived in view of the above-described circumstances and it is an object thereof to provide a photovoltaic cell manufacturing method and a photovoltaic cell manufacturing apparatus, which can easily control positions which are irradiated with laser light and with a small number of steps, based on the image in which a region including a structural defect is captured.

### SUMMARY OF THE INVENTION

In order to solve the above-described problems, a photovoltaic cell manufacturing method of a first aspect of the present invention includes: forming a photoelectric converter which has a plurality of compartment elements that are separated by a scribe line, the compartment elements adjacent to each other being electrically connected; detecting a structural defect existing in the compartment elements (defect detection step); obtaining an image by capturing a region including the structural defect and the scribe line with a predetermined definition (capturing step); specifying first number of pixels on the image, the first number of pixels corresponding to a distance between the scribe lines adjacent to each other or corresponding to a width of the scribe line (first specifying step); referring to an actual value indicating the distance between the scribe lines adjacent to each other or indicating the width of the scribe line, the distance being preliminarily stored, and the width of the scribe line being preliminarily stored (reference step); calculating an actual size of one pixel on the image by comparing the first number of pixels with the actual value (first calculation step); specifying second number of pixels on the image, the second number of pixels corresponding to the distance between the structural defect and the scribe line (second specifying step); comparing the second number of pixels with the actual size of one pixel, thereby calculating defect position information indicating an actual size from the scribe line to a position in which the structural defect exists (second calculation step); and controlling a position that is to be irradiated with laser light based on the defect position information, and electrically separating the structural defect by irradiation with the laser light (repairing step).

In order to solve the above-described problems, in a photovoltaic cell manufacturing apparatus of a second aspect of the present invention, the photovoltaic cell including a photoelectric converter which has a plurality of compartment elements that are separated by a scribe line, the compartment elements adjacent to each other being electrically connected, the apparatus includes: a capturing section that captures a region including a structural defect existing in the compartment elements and the scribe line with a predetermined definition; an image processing section that specifies first number of pixels and second number of pixels on an image obtained by the capturing section, the first number of pixels corresponding to a distance between the scribe lines adjacent to each other or corresponding to a width of the scribe line, the second number of pixels corresponding to the distance between the structural defect and the scribe line; a memory that stores an actual value indicating a width of the compartment element or the width of the scribe line; a calculation section that calculates an actual size of one pixel on the image by comparing the first number of pixels with the actual value and that calculates defect position information indicating an actual size from the scribe line to a position in which the structural defect exists by comparing the actual size of one pixel with the second number of pixels; and a laser irradiation section that controls a position that is to be irradiated with laser light based on the defect position information, and irradiates with the laser light.

### Effect of the Invention

According to the photovoltaic cell manufacturing method of the first aspect of the present invention, the actual size per one pixel is calculated every time based on the predetermined actual size value (actual value) which is preliminarily stored in the memory and the number of pixels constituting the actual size value, even in a case where the distance between the capturing section and the photovoltaic cell varies for each production lot of photovoltaic cells due to a slight difference in thickness or the like, or the actual size per one pixel on the image varies due to an increase in the capturing magnification ratio for improvement of the degree of detection accuracy of the structural defect.

For this reason, it is not necessary for a step requiring time and effort in which the actual size per one pixel is freshly calculated for each production lot of photovoltaic cells or every changing capturing magnification ratio, thereafter, a stage is transferred and the position which is irradiated with laser light is adjusted; the length of time required for a step for repairing a defect of photovoltaic cells is eliminated, and it is possible to significantly increase the efficiency in the repairing step.

Also, since it is not necessary to form a laser vestige used for marking on the compartment element of the photovoltaic cell every calculating of the actual size per one pixel, it is possible to manufacture a photovoltaic cell having a high level of power generation efficiency without unnecessary damage to a compartment element.

Additionally, according to the photovoltaic cell manufacturing apparatus of the second aspect of the present invention, since it is not necessary to form a laser vestige used for marking on the compartment element of the photovoltaic cell every calculating of the actual size per one pixel, it is possible to manufacture a photovoltaic cell having a high level of power generation efficiency without unnecessary damage to a compartment element.

### BRIEF DESCRIPTION OF THE DRAWINGS

FIG. 1 is an enlarged perspective view showing an example of an amorphous silicon photovoltaic cell.
FIG. 2A is a cross-sectional view showing an example of an amorphous silicon photovoltaic cell.
FIG. 2B is a cross-sectional view showing an example of an amorphous silicon photovoltaic cell, and is an enlarged view in which the portion indicated by reference numeral B in FIG. 2A is enlarged.
FIG. 3 is a flowchart illustrating the photovoltaic cell manufacturing method of the present invention.
FIG. 4 is a cross-sectional view showing an example of a structural defect which exists in the photovoltaic cell.
FIG. 5 is a schematic diagram showing a defect position specifying-repairing apparatus (photovoltaic cell manufacturing apparatus).
FIG. 6A is a plan view illustrating a state where a defect position is specified.
FIG. 6B is a plan view illustrating a state where a defect position is specified, and is an enlarged view in which the portion indicated by reference numeral C in FIG. 6A is enlarged.
FIG. 6C is a plan view illustrating a state where a defect position is specified.

### DESCRIPTION OF THE PREFERRED EMBODIMENTS

Hereinafter, the best mode of a photovoltaic cell manufacturing method and a photovoltaic cell manufacturing apparatus used therefor related to the present invention will be described with reference to drawings.

The embodiment is specifically explained for appropriate understanding of the scope of the present invention.

The technical scope of the invention is not limited to the embodiments described below, but various modifications may be made without departing from the scope of the invention.

In the respective drawings used in the explanation described below, in order to make the respective components be of understandable size in the drawing, the dimensions and the proportions of the respective components are modified as needed compared with the real components.

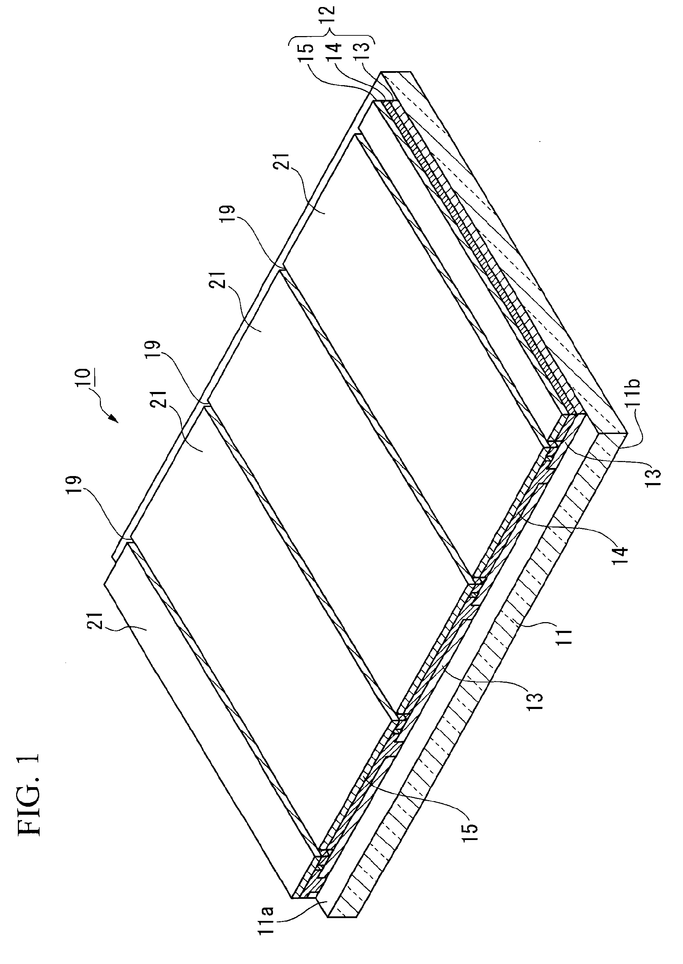

FIG. 1 is an enlarged perspective view showing an example of a main section of an amorphous silicon type photovoltaic cell which is manufactured by a method for manufacturing a photovoltaic cell of the present invention.

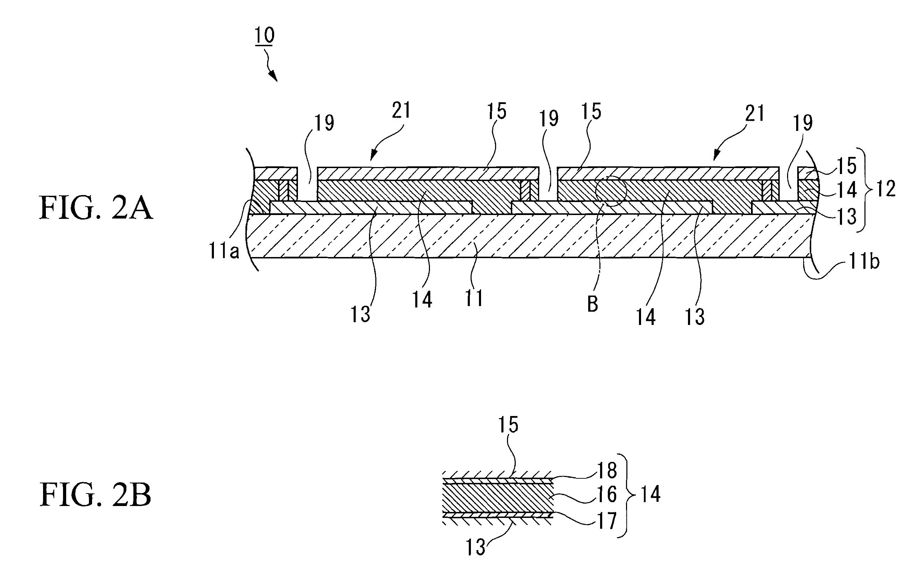

In addition, FIG. 2A is a cross-sectional view showing a layered structure of the photovoltaic cell shown in FIG. 1.

FIG. 2B is an enlarged view showing an enlarged portion indicated by reference numeral B in FIG. 2A.

A photovoltaic cell 10 has a photoelectric converter 12 formed on a first face 11a (one of faces) of a transparent substrate 11 having an insulation property.

The substrate 11 is formed of an insulation material having a high level of sunlight transparency and durability such as a karas or a transparent resin.

Sunlight is incident on a second face 11b (the other of faces) of the substrate 11.

In the photoelectric converter 12, a first electrode layer 13 (lower electrode), a semiconductor layer 14, and a second electrode layer 15 (upper electrode) are stacked in layers in order from the substrate 11.

The first electrode layer 13 (lower electrode) is formed of a transparent conductive material, for example, an oxide of metal having an optical transparency such as TCO or ITO (Indium Tin Oxide).

In addition, the second electrode layer 15 (upper electrode) is formed of a conductive metal film such as Ag or Cu.

As shown in FIG. 2B, the semiconductor layer 14 has, for example, a pin-junction structure in which an i-type amorphous silicon film 16 is formed and sandwiched between a p-type amorphous silicon film 17 and an n-type amorphous silicon film 18.

Consequently, when sunlight is incident to the semiconductor layer 14, electrons and holes are generated, electrons and holes actively transfer due to a difference in the electrical potentials between the p-type amorphous silicon film 17 and the n-type amorphous silicon film 18; and a difference in the electrical potentials between the first electrode layer 13 and the second electrode layer 15 is generated when the transfer thereof is continuously repeated (photoelectric conversion).

The photoelectric converter 12 is divided by scribing lines 19 (scribe line) into a plurality of compartment elements 21, 21 ··· whose external form is a longitudinal rectangular shape.

The compartment elements 21, 21 ··· are electrically separated from each other, and adjacent compartment elements 21 are electrically connected in series therebetween.

In this structure, the photoelectric converter 12 has a structure in which all of the compartment elements 21, 21 ··· are electrically connected in series.

In the structure, it is possible to extract an electrical current with a high degree of difference in the electrical potentials.

The scribing lines 19 are formed, for example, by forming grooves with a predetermined distance therebetween on the photoelectric converter 12 using laser light or the like after the photoelectric converter 12 is uniformly formed on the first face 11a of the substrate 11.

In addition, it is preferable that a protective layer (not shown) made of a resin of insulation or the like be further formed on the second electrode layer 15 (upper electrode) constituting the foregoing photoelectric converter 12.

A manufacturing method for manufacturing a photovoltaic cell having the foregoing structure will be described.

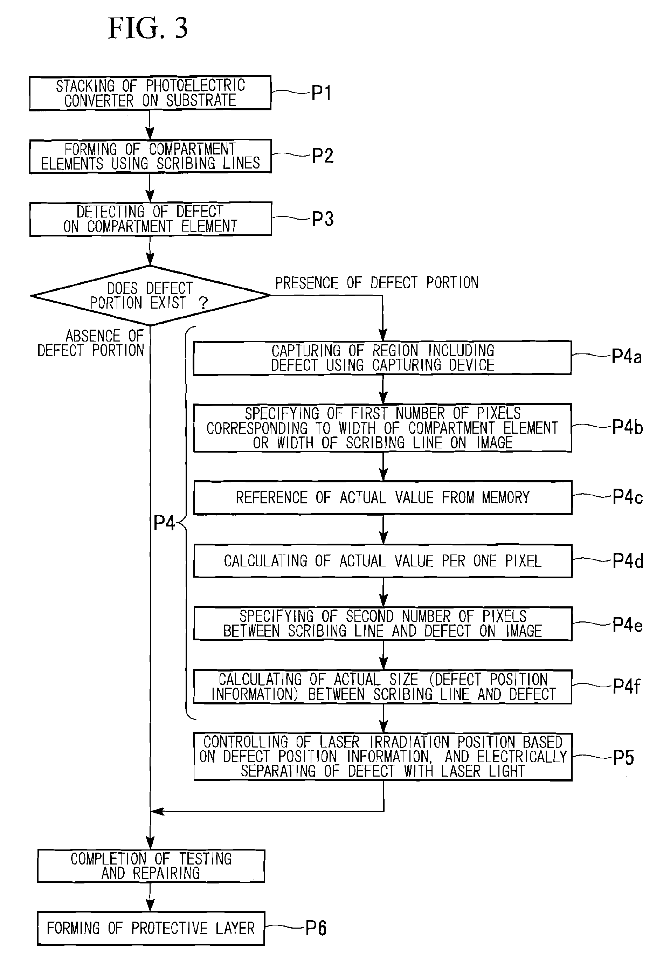

FIG. 3 is a flowchart illustrating a method for manufacturing the photovoltaic cell of the present invention in a stepwise manner.

In the method, specifically, steps between a step of specifying a structural defect and a step of repairing will be described in detail.

Firstly, as shown in FIG. 1, a photoelectric converter 12 is formed on a first face 11a of a transparent substrate 11 (photoelectric converter formation step: P1).

As a structure of the photoelectric converter 12, for example, a structure in which a first electrode layer 13 (lower electrode), a semiconductor layer 14, and a second electrode layer 15 (upper electrode) are stacked in layers in order from the first face 11a of the substrate 11 is employed.

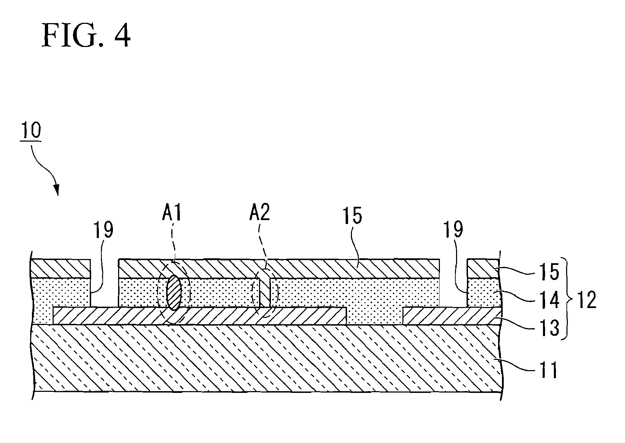

In the step of forming the photoelectric converter 12 having the foregoing structure, as shown in FIG. 4A, there is a case where malfunction is generated such as a structural defect A1 which is generated and caused by mixing impurities or the like into the semiconductor layer 14 (contamination) or a structural defect A2 at which microscopic pin holes are generated in the semiconductor layer 14.

The foregoing structural defects A1 and A2 cause the first electrode layer 13 and the second electrode layer 15 to be locally short-circuited (leakage) therebetween, and degrade the power generation efficiency.

Next, scribing lines 19 (scribe line) are formed by irradiating the photoelectric converter 12 with, for example, a laser beam or the like; a plurality of separated compartment elements 21, 21 ··· which are formed in a longitudinal rectangular shape (compartment element formation step: P2).

In the photovoltaic cell 10 formed by the steps as described above, structural defects which exist in the compartment elements 21, 21 ··· (defects typified by the above-described A1 and A2) are detected (defect detection step: P3).

In a method for detecting the structural defects which exist in the compartment elements 21, 21 ··· in the defect detection step, a predetermined defect-detection apparatus is employed.

The types of the defect-detection apparatus are not limited.

As an example of the defect-detection method, a method is adopted in which resistances between adjacent compartment elements 21 and 21 are measured in the long side direction of the compartment element 21 by a predetermined distance, and a region where the resistances decrease, that is, a rough region where it is predicted that a defect causing short-circuiting exists is specified.

Additionally, for example, a method is adopted in which a bias voltage is applied to the entirety of a compartment element, and a rough region in which a structural defect exists is specified by detecting Joule heat generated in a short-circuited portion (portion in which a structural defect exists) with an infrared light sensor.

When the rough region in which a structural defect exists is confirmed (found) in the compartment elements 21, 21 ··· using the above-described method, subsequently, as a previous step for electrically separating the structural defect using laser light, exact positions of the structural defect are measured (defect position specifying step: P4).

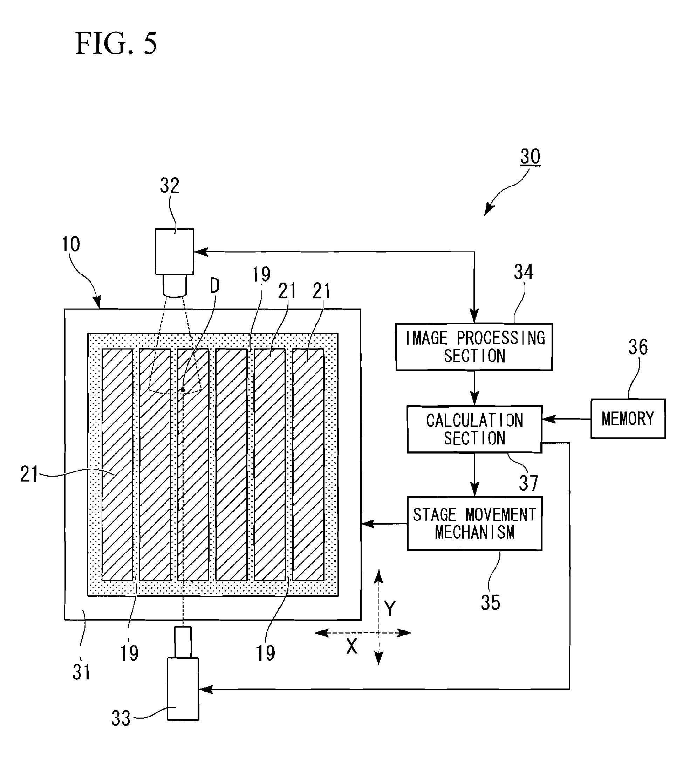

FIG. 5 is a schematic diagram showing a defect position specifying-repairing apparatus (photovoltaic cell manufacturing apparatus) of the present invention, which is used in a defect position specifying step or in a repairing step that is the next step.

The defect position specifying-repairing apparatus 30 includes a stage (transfer stage) 31 on which the photovoltaic cell 10 is mounted, and a capturing section 32 (camera) which captures the compartment elements 21, 21 ··· of the photovoltaic cell 10 mounted on the stage 31 with a predetermined definition.

In addition, an image processing section 34 which treats a captured image data is connected to the capturing section 32.

Moreover, a calculation section 37, which performs a comparison of the number of pixels of the image with an actual size value (actual value) or the like, is connected to the image processing section 34.

A stage movement mechanism 35 which controls the movement of the stage 31 is connected to the stage 31.

Also, the defect position specifying-repairing apparatus 30 has a laser irradiation section 33 which serves as a repairing section (repairing apparatus) electrically separating off (removing) the structural defect D of the compartment elements 21, 21 ···.

Namely, in the defect position specifying-repairing apparatus 30, the photovoltaic cell 10 which is mounted on the stage 31 can be transferred relatively to the capturing section 32, and the photovoltaic cell 10 can be transferred relatively to the laser irradiation section 33.

The stage 31 can move in X-axis and Y-axis directions with a predetermined accuracy while, for example, the photovoltaic cell 10 is mounted on the stage 31.

As the capturing section 32, for example, a camera provided with a solid-state image sensing device (CCD) is employed.

The laser irradiation section 33 is fixed at a predetermined position, and the substrate 11 of the photovoltaic cell 10 is irradiated with laser light from the laser irradiation section 33.

As the laser irradiation section 33, a light source emitting, for example, green laser light is employed.

The stage movement mechanism 35 moves the stage 31 in the X-axis and Y-axis directions, and the position which is irradiated with the laser light is thereby controlled on the substrate 11.

On the image that is obtained by the capturing section 32 with a predetermined definition, the image processing section 34 specifies a compartment element 21, scribing lines 19, a structural defect D, or the like based on the contrast ratio which is caused by a difference in height (difference in thickness) or the like between the formation portion of the compartment element 21 and the region of the scribing line 19.

The calculation section 37 is constituted of, for example, CPU or the like, and compares the number of pixels representing the width of the compartment element 21 which is obtained by the image processing section 34 (distance between adjacent scribing lines), and the actual size value.

Additionally, the calculation section 37 outputs movement data to the stage movement mechanism 35 based on the resultant actual size per one pixel data or the like.

Also, a memory 36 that stores a value representing the actual width of each compartment element 21 or a value representing the actual width of the scribing line 19 is connected to the calculation section 37.

In the defect position specifying step (P4), the stage 31 moves so that a rough region in which a structural defect detected in the defect detection step (P3) of the a previous step exists coincides with the capturing scope of the capturing section 32 by use of the above-described defect position specifying-repairing apparatus 30.

Consequently, the structural defect D which exists at the compartment element 21 and the image including the scribing lines 19 adjacent to the structural defect D are captured with a predetermined magnification ratio and a predetermined definition (capturing step: P4a).

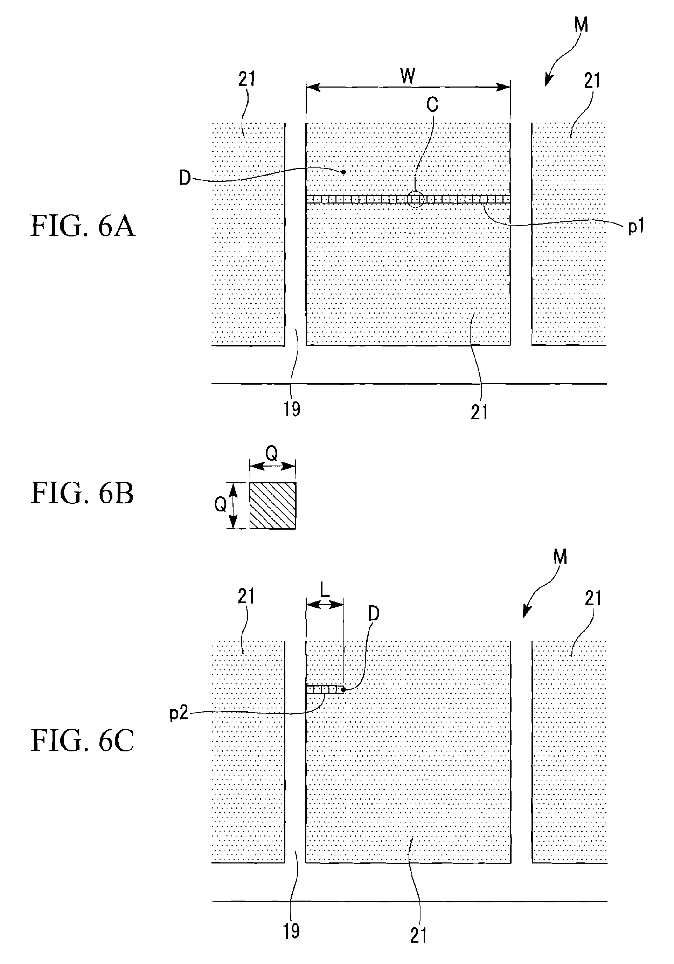

FIG. 6A is a schematic view showing an example of an image M that is obtained by the capturing section 32.

Data of the image M obtained by the capturing section 32 is transmitted to the image processing section 34.

In the image processing section 34, the compartment element 21 and the scribing lines 19 are specified on the image M based on the contrast ratio of the image M or the like (P4b).

Consequently, the number of pixels corresponding to the width of the compartment element 21 or the number of pixels corresponding to the width of the scribing line 19 is detected on the image M, and first number of pixels p1 is thereby obtained (first specifying step).

In an example shown in FIG. 6A, the first number of pixels p1 corresponding to the width w of the compartment element 21 coincides with 27 of pixels on the image M.

In addition, the definition of the image M that is obtained by capturing the photovoltaic cell as a practical matter is finer than the above-described definition of the 27 of pixels.

In FIG. 6A, the pixel size is considerably roughly expressed for convenience in explanation.

The resultant first number of pixels p1 in the above-described manner is input to the calculation section 37.

Subsequently, the calculation section 37 reads out the value representing the actual width of each compartment element 21 or the value representing the actual width of the scribing line 19 from the memory 36 (reference step: P4c).

In an example shown in FIG. 6A, the value representing the actual width of each compartment element 21 is read out.

Thereafter, comparing the value representing the actual width of each compartment element 21 and the first number of pixels p1 corresponding to the width w of the compartment element 21, an actual size value Q per one pixel is calculated (first calculation step: P4d (refer to FIG. 6B).

Subsequently, the image processing section 34 detects the number of pixels corresponding to the distance between the edge of the scribing line 19 and the structural defect D on the image M, and inputs the number of pixels to the calculation section 37 as second number of pixels p2 (second specifying step: P4e (refer to FIG. 6C).

Consequently, in the calculation section 37, the second number of pixels p2 is compared with actual size value Q per one pixel, and defect position information representing an actual size value L between the edge of the scribing line 19 and the structural defect D is obtained (second calculation step: P4f).

Based on the resultant defect position information representing the actual size value L between the edge of the scribing line 19 and the structural defect D in the described above defect position specifying step (P4), the stage 31 is guided such that the position which is irradiated with the laser light coincides with the position adjacent to the structural defect D with a high level of precision.

Consequently, a repair line surrounding the structural defect D is formed by focusing and irradiating the structural defect D with the laser light from the laser irradiation section 33 (repairing step: P5).

For this reason, the structural defect D is electrically separated off (removed) from the region in which the defects do not exist.

According to the described above steps, the actual size per one pixel is calculated every time based on the predetermined actual size value which is preliminarily stored in the memory and the number of pixels constituting the actual size value, even in a case where the distance between the capturing section 32 and the photovoltaic cell 10 varies for each production lot of photovoltaic cells 10 due to a slight difference in thickness or the like, or the actual size per one pixel on the image varies due to an increase in the capturing magnification ratio for improvement of the degree of detection accuracy of the structural defect.

For this reason, it is not necessary for a step requiring time and effort in which the actual size per one pixel is freshly calculated for each production lot of photovoltaic cells 10 or every changing capturing magnification ratio, thereafter, a stage is transferred and the position which is irradiated with laser light is adjusted; the length of time required for a step for repairing a defect of photovoltaic cells 10 is eliminated, and it is possible to significantly increase the efficiency in the repairing step.

Also, since it is not necessary to form a laser vestige used for marking on the compartment element of the photovoltaic cell every calculating of the actual size per one pixel, it is possible to manufacture a photovoltaic cell 10 having a high level of power generation efficiency without unnecessary damage to a compartment element.

After the steps described above, all of the structural defects D which exist in the compartment element 21 are electrically separated off (removed), thereafter, a step for forming a protective layer (P6) or the like is performed, and a photovoltaic cell as product is obtained.

### Industrial Applicability

As described above, the present invention is applicable to a photovoltaic cell manufacturing method and a photovoltaic cell manufacturing apparatus in which positions which are irradiated with laser light can be easily controlled in a small number of steps based on an image in which a region including a structural defect is captured.

## Claims

1. A photovoltaic cell manufacturing method comprising:
forming a photoelectric converter which has a plurality of compartment elements that are separated by a scribe line, the compartment elements adjacent to each other being electrically connected;
detecting a structural defect existing in the compartment elements;
obtaining an image by capturing a region including the structural defect and the scribe line with a predetermined definition;
specifying first number of pixels on the image, the first number of pixels corresponding to a distance between the scribe lines adjacent to each other or corresponding to a width of the scribe line;
referring to an actual value indicating the distance between the scribe lines adjacent to each other or indicating the width of the scribe line, the distance being preliminarily stored, and the width of the scribe line being preliminarily stored;
calculating an actual size of one pixel on the image by comparing the first number of pixels with the actual value;
specifying second number of pixels on the image, the second number of pixels corresponding to the distance between the structural defect and the scribe line;
comparing the second number of pixels with the actual size of one pixel, thereby calculating defect position information indicating an actual size from the scribe line to a position in which the structural defect exists; and
controlling a position that is to be irradiated with laser light based on the defect position information, and electrically separating the structural defect by irradiation with the laser light.

2. A photovoltaic cell manufacturing apparatus, the photovoltaic cell including a photoelectric converter which has a plurality of compartment elements that are separated by a scribe line, the compartment elements adjacent to each other being electrically connected, the apparatus comprising:
a capturing section that captures a region including a structural defect existing in the compartment elements and the scribe line with a predetermined definition;
an image processing section that specifies first number of pixels and second number of pixels on an image obtained by the capturing section, the first number of pixels corresponding to a distance between the scribe lines adjacent to each other or corresponding to a width of the scribe line, the second number of pixels corresponding to the distance between the structural defect and the scribe line;
a memory that stores an actual value indicating a width of the compartment element or the width of the scribe line;
a calculation section that calculates an actual size of one pixel on the image by comparing the first number of pixels with the actual value and that calculates defect position information indicating an actual size from the scribe line to a position in which the structural defect exists by comparing the actual size of one pixel with the second number of pixels; and
a laser irradiation section that controls a position that is to be irradiated with laser light based on the defect position information, and irradiates with the laser light.
